# EUROPÄISCHE PATENTANMELDUNG

(11) **EP 3 702 200 A2**
(43) Veröffentlichungstag der Anmeldung: **02.09.2020**
(21) Anmeldenummer: 20159817.4
(22) Anmeldetag: 27.02.2020
(51) Int. Cl.: B60L 53/30

(54) **VERSORGUNGSSTATION, VERSORGUNGSPUNKTMODUL UND INSTALLATIONSVERFAHREN**

(30) Priorität: 28.02.2019 DE 102019105153
(71) Anmelder: Elektro-Bauelemente GmbH, 44536 Lünen (DE)
(72) Erfinder: Kachouh, Checrallah, 44227 Dortmund (DE)
(74) Vertreter: Wickord, Wiro

(57) **Zusammenfassung**

Die Erfindung betrifft eine Versorgungsstation (6) umfassend ein Stationsgehäuse (23), welches ein zentrales Steuermodul (24), ein Versorgungspunktmodul (1, 1.1, 1.2) mit einem Steckelement (5) und eine zu dem Versorgungspunktmodul (8) geführte Versorgungspunktanschlussleitung (7, 7.1, 7.2) umgreift, wobei das Versorgungspunktmodul (1, 1.1, 1.2) als ein eigenständiges, werksseitig vormontiertes Submodul das Steckelement (5), mechanische Kontaktmittel zum elektrischen Kontaktieren des Versorgungspunktmoduls (1, 1.1, 1.2)und einen Zähler (4) mit einer Messeinrichtung (9) und einem Messcontroller (10) umfasst, wobei die mechanischen Kontaktmittel die Versorgungspunktanschlussleitung (7, 7.1, 7.2) mit einem Versorgungsmodulleiter (8) verbinden, wobei der Versorgungsmodulleiter (8) von der Messeinrichtung (9) des Zählers (4) zu dem Steckelement (5) geführt ist und wobei der Messcontroller (10) ausgebildet ist zur Verarbeitung von Messwerten, welche mittels der Messeinrichtung (9) bestimmt sind. Ferner betrifft die Erfindung ein Versorgungspunktmodul (1, 1.1, 1.2) für eine Versorgungsstation (6) und ein Installationsverfahren für eine Versorgungsstation (6).

## Beschreibung

Die Erfindung betrifft eine Versorgungsstation insbesondere zur Bereitstellung von elektrischer Energie für nicht-stationäre elektrische Betriebsmittel wie beispielsweise elektrisch betriebene Fahrzeuge. Ferner betrifft die Erfindung ein Versorgungspunktmodul für eine Versorgungsstation und ein Installationsverfahren für eine Versorgungsstation.

Üblicherweise werden Versorgungsstationen der vorgenannten Art heute werksseitig montiert und an einem Installationsort auf einem dort vorbereitenden Sockel oder wandseitig installiert. Neben der mechanischen Befestigung wird bei der Installation der Versorgungsstation die elektrische Verbindung zu einem Versorgungsnetz, beispielsweise einem kommunalen Versorgungsnetz hergestellt. Hierzu wird üblicherweise eine Zuleitung an mechanische Kontaktmittel, beispielsweise Klemmen eines Anschlussmoduls der Versorgungsstation angeschlossen.

Sofern über die Versorgungsstation elektrische Energie kostenpflichtig bereitgestellt wird, ist es regelmäßig erforderlich, nationale, regionalen oder internationalen Gesetze beziehungsweise Vorgaben in Bezug auf die Abrechnung der Energie zu berücksichtigen und ihnen durch technische und/der prozessuale Mittel Genüge zu tun. Beispielsweise sind in Deutschland die Vorgaben des nationalen Eichrechts zu beachten. Es ist insofern erforderlich, die Abrechnung der Energieabgabe eichrechtskonform durchzuführen. Neben der Verwendung geeichter Zähler muss die Versorgungsstation beispielsweise manipulationsgeschützt realisiert werden. Dies gilt in Bezug auf mechanische Manipulationsversuche sowie Computer- beziehungsweise IT-gestützte Manipulationsversuche gleichermaßen. Sicherzustellen ist hierbei vorrangig, dass die dem Kunden in Rechnung gestellte Energie tatsächlich an den Kunden abgegeben wurde. Diese Vorgabe wird beispielsweise dadurch erfüllt, dass nach der Montage der Versorgungsstation eine eichrechtlich relevante Kontrollmessung durchgeführt wird, bei der eine über äußere Kontakte eines Steckelements der Versorgungsstation abgegebene Energiemenge mit der von dem geeichten Zähler erfassten Energiemenge verglichen wird. Sofern die Messwerte einander entsprechen oder innerhalb eines vorgegebenen Toleranzbereichs liegen, ist die Installation der Versorgungsstation ordnungsgemäß. Diese Kontrollmessung muss nach der Erstinstallation der Versorgungsstation nach jedem Wartungsbeziehungsweise Installationszugriff, der sich auf die eichrechtsrelevanten Funktionskomponenten auswirkt, erneut durchgeführt werden. Gerade vor Ort ist dies aufwendig und zeitintensiv.

Eine manipulationsgeschützt ausgebildete Versorgungsstation ist aus der DE 10 2017 105 014 A1 bekannt. Die Versorgungsstation sieht einen geeichten Zähler vor, der über eine geschützte Datenleitung mit einem Sicherheitsmodul zusammenwirkt, wobei die Messdaten des Zählers in dem Sicherheitsmodul manipulationsgeschützt gespeichert sind. Über eine weitere geschützte Datenleitung wirkt das Sicherheitsmodul mit einer Steuereinheit der Versorgungsstation manipulationsgeschützt zusammen.

Aufgabe der vorliegenden Erfindung ist es, eine in Bezug auf die ordnungsgemäße Bereitstellung und Abrechnung der Energieabgabe optimierte Versorgungsstation, eine geeignet ausgebildetes Versorgungspunktmodul und ein verbessertes Installationsverfahren anzugeben.

Zur Lösung der Aufgabe weist die Erfindung die Merkmale des Patentanspruchs 1 auf. Demzufolge umfasst die Versorgungsstation ein Stationsgehäuse, welches die folgenden Funktionskomponenten der Versorgungsstation jedenfalls abschnittweise umgreift:
- ein zentrales Steuermodul, welches ausgebildet ist zur Verarbeitung einer Nutzer- und/oder Kundenkennung und/oder zur Freigabe eines Ladevorgangs,
- ein Versorgungspunktmodul mit einem Steckelement, wobei das Steckelement innere und äußere Kontakte vorsieht, wobei die inneren Kontakte elektrisch leitend mit den äußeren Kontakten verbunden sind, wobei die inneren Kontakte mit einem Versorgungsmodulleiter des Versorgungspunktmoduls verbunden sind und wobei die äußeren Kontakte des Steckelements mittelbar oder unmittelbar mit dem nicht-stationären elektrischen Betriebsmittel verbindbar ist, und
- eine zu dem Versorgungspunktmodul geführte Versorgungspunktanschlussleitung.

Dabei ist das Versorgungspunktmodul als ein eigenständiges, werksseitig vormontiertes Submodul der Versorgungsstation ausgebildet, welches das Steckmodul, mechanische Kontaktmittel zum elektrischen Kontaktieren des Versorgungspunktmoduls und einen Zähler mit einer Messeinrichtung und mit einem Messcontroller umfasst. Die Ladepunktanschlussleitung ist über die mechanischen Kontaktmittel mit dem Versorgungsmodulleiter verbunden. Der Versorgungsmodulleiter ist von der Messeinrichtung des Zählers zu den inneren Kontakten des Steckelements geführt. Der Messcontroller des Zählers wirkt mit der Messeinrichtung zusammen und verarbeitet die Messwerte der Messeinrichtung. Beispielsweise ist der Zähler als ein geeichter Zähler ausgebildet.

Der besondere Vorteil der Erfindung besteht darin, dass die abrechnungsrelevanten Funktionskomponenten der Versorgungsstation durch das separate realisierte Versorgungspunktmodul bereitgestellt werden. Insofern kann eine Funktionskontrolle beziehungsweise die eichrechtlich relevante Kontrollmessung an dem Versorgungspunktmodul durchgeführt werden. Die Versorgungsstation insgesamt muss nicht vollständig hergestellt beziehungsweise installiert sein, um die eichrechtskonforme Funktion der abrechnungsrelevanten Funktionskomponenten der Versorgungsstation beziehungsweise des Versorgungspunktmoduls zu prüfen. Insbesondere kann die eichrechtsrelevante Kontrollmessung an dem werksseitig vorgefertigten Versorgungspunktmodul durchgeführt werden. Das Versorgungspunktmodul muss zum Zeitpunkt der Kontrollmessung nicht in der Versorgungsstation verbaut vorgesehen sein. Beispielsweise kann die Kontrollmessung im Werk durchgeführt werden. Das Versorgungspunktmodul kann nach der erfolgreichen Durchführung der eichrechtsrelevanten Kontrollmessung als geeichtes Versorgungsmodul eingesetzt werden zur Abrechnung des Versorgungsvorgangs gegenüber dem Kunden beziehungsweise Nutzer.

Weiter kann nach der Installation der Versorgungsstation auf eine neuerliche Kontrollmessung beispielsweise nach der Durchführung von Wartungsbeziehungsweise Installationsarbeiten verzichtet werden, sofern die Wartungsbeziehungsweise Installationsarbeiten sich nicht auf das Versorgungspunktmodul bezogen haben. Wartungs- beziehungsweise Installationsarbeiten an dem zentralen Steuermodul der Versorgungsstation, dem Anschlussmodul, den Leitungssicherungen, den Fehlerstrom-Schutzschaltern, dem Netzteil, dem Stationsgehäuse oder der Versorgungspunktanschlussleitung sind möglich, ohne eine neue Kontrollmessung durchzuführen und/oder ohne die Eichrechtskonformität erneut zu prüfen.

Im Sinne der Erfindung sind der Zähler beziehungsweise das Versorgungspunktmodul der erfindungsgemäßen Versorgungsstation geeicht, wenn sie nach den lokalen, nationalen beziehungsweise länderübergreifenden Vorgaben zugelassen sind, um zu Abrechnungszwecken eingesetzt zu werden. Beispielsweise werden Energiezähler beziehungsweise Versorgungspunktmodule mit einer Konformitätsbescheinigung, beispielsweise MID-konforme Energiezähler beziehungsweise Versorgungspunktmodule als geeichte Energiezähler im Sinne der Erfindung aufgefasst.

Nicht-stationäre elektrische Betriebsmittel sind beispielsweise Fahrzeuge. Als Fahrzeuge gelten beispielsweise alle Automobile (unter anderem PKW, LKW, Wohnmobile, Zweiräder, Busse, Transporter), Schienenfahrzeuge (insbesondere Lokomotiven), Wasserfahrzeuge (Schiffe), Luftfahrzeuge sowie Anhänger (Wohnanhänger) und mobile Verkaufsstände. Die Versorgungsstation beziehungsweise das Versorgungspunktmodul können verwendet werden zum Bereitstellen von elektrischer Energie für Fahrzeuge mit und ohne Energiespeicher.

Eine Versorgungsstation dient insbesondere der Bereitstellung elektrischer Energie gegenüber einem nicht-stationären elektrischen Betriebsmittel, wobei das elektrische Betriebsmittel optional einen eigenen Energiespeicher aufweisen kann. Ferner kann vorgesehen sein, dass die Versorgungsstation zum Entladen eines elektrischen Energiespeichers eines nicht-stationären elektrischen Betriebsmittels, beispielsweise eines Fahrzeugs verwendet wird. Die dem Energiespeicher entnommene Energie wird beispielsweise in das externe Versorgungsnetz eingespeist. Der Zähler wird insofern bedarfsgerecht als Zweirichtungszähler ausgeführt, um gegebenenfalls für den Bereitstellungs- und Einspeisevorgang gleichermaßen verwendet zu werden.

Als Versorgungsmodulleiter kann beispielsweise ein Kabel beziehungsweise eine ummantelte Leitung, insbesondere eine Kupferleitung vorgesehen werden. Beispielsweise kann ein gestanzter Leiter, insbesondere ein gestanzter Kupferleiter oder einer Leiter auf einer Leiterplatte als Versorgungsmodulleiter dienen.

Als mechanische Kontaktmittel kann das Versorgungspunkt-Submodul beispielsweise Kontaktklemmen oder Schraubkontakte vorsehen. Beispielsweise können offene Kabelenden des Versorgungsmodulleiters (pigtail wire) die mechanischen Kontaktmittel bilden.

Beispielsweise kann das zentrale Steuermodul der Versorgungsstation, welches nicht als Komponente des Versorgungspunktmoduls realisiert ist, versorgungsnetzseitig unmittelbar oder mittelbar über einen Versorgungsschaltung, ein Netzteil, einem Trafo, einen sonstigen Wandler oder dergleichen mit Energie versorgt werden. Beispielsweise kann das zentrale Steuermodul von dem Versorgungspunktmodul mit Energie versorgt werden. Aus dem Versorgungspunktmodul ist in diesem Fall eine Steuermodulversorgungsleitung herausgeführt.

Nach einer bevorzugten Ausführungsform der Erfindung ist das Versorgungspunktmodul der Versorgungsstation als ein manipulationsgeschütztes Versorgungspunktmodul ausgebildet derart, dass der Versorgungsmodulleiter jedenfalls zwischen der Messeinrichtung und den internen Kontakten des Steckelements und/oder in Bezug auf die mechanischen Kontaktelemente der Messeinrichtung und die inneren Kontakte des Steckelements mechanisch unzugänglich und/oder gekapselt ausgebildet sind und/oder dass eine Kommunikationsschnittstelle des Messcontrollers rückwirkungsfrei ausgebildet ist. Eine Kapselung im Sinne der Erfindung ist beispielsweise durch einen Isolationsmantel einer Leitung beziehungsweise eines Kabels realisiert.

Im Sinne der Erfindung gilt eine Kommunikationsschnittstelle als rückwirkungsfrei, wenn sie gemäß der PTB-A 50.7 der Physikalisch-Technischen Bundesanstalt (Stand: 2002) oder gleichwertiger sonstiger lokaler, nationaler beziehungsweise länderübergreifender Standards realisiert ist. Hiervon umfasst ist unter anderem die elektrische Rückwirkungsfreiheit derart, dass durch Kurzschlüsse zwischen beliebigen Anschlüssen eichtechnisch relevante Funktionen und Daten, welche in dem Versorgungspunktmodul beziehungsweise dem Messcontroller realisiert, verarbeitet oder gespeichert sind, nicht beeinflusst werden. Darüber hinaus ist die Kommunikationsschnittstelle logisch rückwirkungsfrei ausgebildet derart, dass die speziellen Softwareanforderungen nach dem Anhang PTB-A 50.7-1 zur vorstehend genannten Norm realisiert sind und insbesondere nur vorab definierte Zugriffe durchgeführt und/oder Daten übertragen werden können. Es ist hierbei insbesondere berücksichtigt, dass die Verarbeitungsroutinen des Messcontrollers über die Kommunikationsschnittstelle nicht in unzulässiger Weise beeinflusst werden können. Der Manipulationsschutz kann darüber hinaus insbesondere durch mechanische Funktionskomponenten realisiert werden.

Nach einer Weiterbildung der Erfindung ist das Manipulationsschutzgehäuse von dem Stationsgehäuse umgriffen und es ist an dem Stationsgehäuse und/oder an dem Manipulationsgehäuse eine Ausnehmung vorgesehen, über die das Steckelement des Versorgungspunktmoduls für einen Nutzer zugänglich und/oder bereitgestellt ist. Beispielsweise ist das Steckelement in dem Gehäuse der Versorgungsstation selbst angeordnet. Optional kann dem Steckelement ein Verschlusselement, beispielsweise eine Klappe zugeordnet sein, welches das Steckelement verdeckt, wenn die Versorgungsstation nicht verwendet wird oder eine Autorisierung des Nutzers noch nicht erfolgt ist, und welches den Zugang zu dem Steckelement freigibt zur Durchführung des Versorgungsvorgangs. Beispielsweise kann das Steckelement endseitig an einem Anschlusskabel der Versorgungsstation angeschlagen sein.

Nach einer Weiterbildung der Erfindung sieht das Versorgungspunktmodul ein mehrteiliges Manipulationsschutzgehäuse vor. Jedenfalls einzeln und bevorzugt alle Gehäusekomponenten des Manipulationsschutzgehäuses sind über Indikationsmittel derart gekennzeichnet und/oder miteinander verbunden, dass ein Öffnen des Manipulationsschutzgehäuses zu einer Beschädigung der Indikationsmittel führt. Vorteilhaft kann durch das Vorsehen des Manipulationsschutzgehäuses mit den Indikationsmitteln eine Manipulation jedenfalls festgestellt und angezeigt werden. Ein in Bezug auf die eichrechtskonforme Abrechnung des Vorgangs relevanter Manipulationseingriff ist hierdurch nachweisbar. Beispielsweise können die Indikationsmittel so angeordnet und platziert sein, dass ein Kunde beziehungsweise Nutzer der Versorgungsstation und/oder eine Marktüberwachungsbehörde sie sehen und eine etwaige Manipulation erkennen kann. Als Indikationsmittel können beispielsweise Prüfplaketten oder Plomben verwendet werden. Die Indikationsmittel können zum Zwecke der Inaugenscheinnahme beispielsweise hinter einer von dem Stationsgehäuse vorgesehenen Scheibe von außen sichtbar angeordnet sein.

Indikationsmittel können ebenfalls vorgesehen sein, um der elektrisch leitenden Verbindung der Funktionskomponenten des Versorgungspunktmoduls dienende mechanische Kontakte beispielsweise der Messeinrichtung beziehungsweise des Steckelements zu schützen und eine elektrisch leitenden Kontaktierung dieser Kontakte zu verhindern. Die Indikationsmittel können die mechanischen Kontakte hierzu beispielsweise überdecken oder umgreifen. Als Indikationsmittel kommen hier beispielsweise selbstklebende Prüf- oder Siegelplaketten zur Anwendung. Die Indikationsmittel dienen insofern der Kapselung der Kontakte.

Nach einer Weiterbildung der Erfindung sieht die Versorgungsstation eine Empfangseinheit zum Empfangen der Nutzer- und/oder Kundenkennung vor. Beispielsweise kann die Empfangseinheit als Teil des Versorgungspunktmoduls realisiert und insbesondere von dem Manipulationsschutzgehäuse umgriffen sein. Alternativ kann vorgesehen sein, dass die Empfangseinheit als Teil des zentralen Steuermoduls der Versorgungsstation außerhalb des Versorgungspunktmoduls vorgesehen ist. Als Empfangseinheit kann beispielsweise ein RFID-Leser vorgesehen sein, der ausgebildet ist zur berührungslosen Erkennung der Nutzer- und/oder Kundenkennung. Die Nutzer- und /oder Kundenkennung kann beispielsweise aus einem RFID-Tag ausgelesen werden. Beispielsweise kann vorgesehen sein, dass die Nutzer- beziehungsweise Kundenkennung unmittelbar von dem Fahrzeug bereitgestellt und beispielsweise über das Anschlusskabel an die Versorgungsstation beziehungsweise das Versorgungspunktmodul übertragen wird. Beispielsweise kann die Nutzer- beziehungsweise Kundenkennung über Eingabemittel der Versorgungsstation beziehungsweise des Versorgungspunktmoduls, insbesondere Tasten, vom Kunden beziehungsweise Nutzer eingegeben werden. Beispielsweise kann die Nutzer- und/oder Kundenkennung von einer ortsfern angeordneten, mit der Versorgungsstation über eine Datenverbindung zusammenwirkenden Zentralstation an die Versorgungsstation übermittelt werden.

Nach einer Weiterbildung der Erfindung sind der Versorgungspunktanschlussleitung eine Leitungssicherung beziehungsweise ein Fehlerstrom-Schutzschalter zugeordnet. Die Leitungssicherung beziehungsweise der Fehlerstrom-Schutzschalter sind bevorzugt als Teil der Versorgungsstation und außerhalb des Versorgungspunktmoduls realisiert.

Nach einer Weiterbildung der Erfindung sieht das Versorgungspunkt-Submodul eine Anschlusseinheit vor, die die mechanischen Kontakte bereitstellt. Der Versorgungspunktleiter ist von der Anschlusseinheit zu der Messeinrichtung und weiter zu den inneren Kontakten des Steckelements geführt. Die Anschlusseinheit dient dazu, das Versorgungspunktmodul elektrisch zu kontaktieren, indem der Versorgungsmodulleiter des Versorgungspunktmoduls und die Versorgungspunktanschlussleitung der Versorgungsstation elektrisch leitend verbunden werden.

Nach einer Weiterbildung der Erfindung sieht die Versorgungsstation ein Anschlussmodul vor, welches nicht als Teil des Versorgungspunktmoduls realisiert ist und dem Anschluss der Versorgungsstation an das Versorgungsnetz dient. Die Zuleitung wird durch das Anschlussmodul mit der wenigstens einen Versorgungspunktanschlussleitung der Versorgungsstation verbunden. Überdies kann die Steuermodulversorgungsleitung von dem Anschlussmodul zu dem zentralen Steuermodul der Versorgungsstation geführt sein.

Nach einer Weiterbildung der Erfindung sieht die Versorgungsstation wenigstens zwei separate Versorgungspunktmodule mit jeweils einem Steckelement, mit jeweils einer Anschlusseinheit und mit jeweils einer Messeinrichtung sowie einem Messcontroller vor. Das Anschlussmodul der Versorgungsstation kann als ein gemeinsames Anschlussmodul ausgebildet sein derart, dass von dem gemeinsamen Anschlussmodul je eine Versorgungspunktanschlussleitung zu jedem Versorgungspunktmodul geführt ist. Separat für jede Versorgungspunktanschlussleitung sind insbesondere die Leitungssicherungen und die Fehlerstrom-Schutzschalter vorgesehen. Alternativ können zwei oder mehr Zuleitungen zu der Versorgungsstation geführt sein zum Anschluss der wenigstens zwei Versorgungspunktmodule.

Im Rahmen der System- beziehungsweise IT-Architektur der Versorgungsstation kann das zentrale Steuermodul datentechnisch und rückwirkungsfrei mit dem Messcontroller und/oder einem zusätzlich vorgesehenen Steuercontroller des wenigstens einen Versorgungspunktmoduls zusammenwirken. Es kann hierbei eine Master-Slave Architektur realisiert sein. Das zentrale Steuermodul koordiniert insofern den Ladevorgang als Master. Der Mess- und/oder Steuercontroller führt als Slave den Ladevorgang abhängig von den Vorgaben des zentralen Steuermoduls durch.

Zur Lösung der Aufgabe weist die Erfindung die Merkmale des Patentanspruchs 8 auf. Demzufolge ist ein Versorgungspunktmodul bereitgestellt, welches die folgenden Komponenten umfasst:
- ein Steckelement, welches innere und äußere Kontakte vorsieht, wobei die inneren Kontakte elektrisch leitend mit den äußeren Kontakten verbunden sind, wobei die inneren Kontakte mit einem Versorgungsmodulleiter verbunden sind und wobei die äußeren Kontakte mittelbar oder unmittelbar mit einem nicht-stationären elektrischen Betriebsmittel verbindbar sind,
- mechanische Kontaktmittel, welche ausgebildet sind zum Anschluss einer Versorgungspunktanschlussleitung,
- den Versorgungsmodulleiter, welche elektrisch leitend mit den mechanischen Kontaktmitteln und mit den inneren Kontakten des Steckelements verbunden ist,
- eine dem Versorgungsmodulleiter zugeordnete Messeinrichtung zum Messen eines elektrischen Betriebsparameters und insbesondere einer über den Versorgungsmodulleiter bereitgestellten elektrischen Energie und/oder einer elektrischen Leistung und/oder eines elektrischen Stroms und/oder einer elektrischen Spannung und/oder einer Frequenz,
- einen mit der Messeinrichtung zusammenwirkenden Messcontroller mit einer Recheneinheit zum Verarbeiten von Messwerten der Messeinrichtung,
wobei der Versorgungsmodulleiter wenigstens abschnittweise und jedenfalls zwischen der Messeinrichtung und den inneren Kontakten des Steckelements und/oder mechanische Kontakte der Messeinrichtung und/oder die inneren Kontakte des Steckelements mechanisch unzugänglich und/oder gekapselt ausgebildet sind und/oder wobei wenigstens eine Kommunikationsschnittstelle vorgesehen ist und die wenigstens eine Kommunikationsschnittstelle rückwirkungsfrei ausgebildet ist.

Beispielsweise sind ein die Messeinrichtung und/oder dem Messcontroller und/oder das Steckelement jedenfalls abschnittsweise umgreifendes, mehrteilig ausgebildetes Manipulationsschutzgehäuse vorgesehen und jedenfalls einzelne und bevorzugt alle Gehäusekomponenten des Manipulationsschutzgehäuses durch Indikationsmittel derart gekennzeichnet und/oder verbunden, dass ein Öffnen des Manipulationsschutzgehäuses zu einer Beschädigung der Indikationsmittel führt.

Optional kann das Versorgungspunktmodul eine dem Anschluss an die Versorgungspunktanschlussleitung dienende Anschlusseinheit aufweisen. Die inneren und äußeren Kontakte des Steckelements können einen gemeinsamen Leiter, beispielsweise ein gestanztes Blechteil aufweisen.

Das Versorgungspunktmodul ist dabei als ein eigenständiges, in sich geschlossenes Submodul beziehungsweise Baugruppe einer Versorgungsstation realisiert, welche alle zur eichrechtskonformen Abrechnung eines Ladevorgangs relevanten Funktionskomponenten umfasst. Es kann separat und insbesondere unabhängig von der Installation der Versorgungsstation einer Funktionskontrolle und eichrechtlichen Kontrollmessung unterzogen werden.

Das Versorgungspunktmodul kann werksseitig oder am Aufstellungsort der Versorgungsstation in ein Stationsgehäuse der Versorgungsstation integriert werden, ohne dass nach der Installation der Versorgungsstation eine eichrechtsrelevante Kontrollmessung durchzuführen wäre. Darüber hinaus ist es möglich, ein Versorgungspunktmodul im Rahmen einer Wartungs- oder Reparaturarbeit an der Versorgungsstation auszutauschen beziehungsweise neu zu verbauen. Sofern das Versorgungspunktmodul werksseitig bereits einer eichrechtsrelevanten Kontrollmessung unterzogen wurde, kann auf eine erneute Kontrollmessung nach dem Austausch beziehungsweise der Installation des Versorgungspunktmoduls verzichtet werden. Der Installationsaufwand vor Ort reduziert sich hierdurch erheblich und es ist möglich, die eichrechtsrelevante Kontrollmessung unter definierten, stets gleichen Bedingungen werksseitig durchzuführen.

Die mechanischen Kontaktmittel des Versorgungspunktmoduls können beispielsweise von der Messeinrichtung bereitgestellt sein. Sofern das Versorgungspunktmodul die Anschlusseinheit aufweist, kann diese die mechanischen Kontaktmittel vorsehen und dem Anschluss des eigenständigen Submoduls an die Versorgungspunktanschlussleitung der Versorgungsstation dienen. Beispielsweise können die mechanischen Kontaktmittel durch offene Kabelenden (pigtails) des Versorgungsmodulleiters gebildet sein.

Nach einer bevorzugten Ausführungsform der Erfindung ist dem Versorgungsmodulleiter ein Schaltmittel zugeordnet zum wahlweisen Herstellen und/oder Trennen einer elektrisch leitenden Verbindung zwischen dem Steckelement und der Anschlusseinheit. Das Schaltmittel ist bevorzugt zwischen der Messeinrichtung und dem Steckelement angeordnet. Mechanische Kontakte, welche an dem Schaltmittel vorgesehen sind und dem Anschluss des Schaltmittels an den Versorgungsmodulleiter dienen, sind manipulationsgeschützt realisiert derart, dass sie analog den mechanischen Kontaktmitteln der Messeinrichtung beziehungsweise den inneren Kontakten des Steckelements mechanisch unzugänglich und/oder gekapselt angeordnet sind. Beispielsweise kann die Kapselung durch das Manipulationsschutzgehäuse des Versorgungspunktmoduls erfolgen. Der Messcontroller kann eine Kommunikationsschnittstelle vorsehen, welche zum rückwirkungsfreien Senden und/oder Empfangen von Daten ausgebildet ist.

Nach einer Weiterbildung der Erfindung sind die Messeinrichtung und der Messcontroller Teil eines geeichten Zählers des Versorgungspunktmoduls. Der Zähler kann als Zweirichtungszähler ausgeführt sein, um gegebenenfalls für den Bereitstellungs- und Einspeisevorgang gleichermaßen verwendet zu werden.

Nach einer Weiterbildung der Erfindung ist zusätzlich zu dem Messcontroller ein mit dem Messcontroller zusammenwirkender Steuercontroller vorgesehen. Der Steuercontroller kann eine Kommunikationsschnittstelle zum Senden und/oder rückwirkungsfreien Empfangen von Daten vorsehen. Der Steuercontroller ist insbesondere ausgebildet zum Betätigen des Schaltmittels und/oder zum Betätigen einer dem Steckelement zugeordneten Verriegelung und/oder einer Statussignalleuchte. Die Verriegelung dient beispielsweise dazu, ein in das Steckelement eingesetztes Gegensteckelement in dem Steckelement festzulegen. Mittels der Statussignalleuchte kann beispielsweise ein laufender Versorgungsvorgang signalisiert, die Betriebsbereitschaft der Versorgungsstation beziehungsweise des Versorgungspunktmoduls angezeigt oder eine Betriebsstörung kenntlich gemacht werden. Beispielsweise kann der Steuercontroller ein mit dem Steckelement kontaktiertes Gegensteckelement detektieren. Darüber hinaus kann der Steuercontroller der Kommunikation mit dem elektrischen Betriebsmittel dienen. Eine Kommunikationsroutine zwischen dem Versorgungspunktmodul und dem elektrischen Betriebsmittel kann beispielsweise als Mode-3-Kommunikation oder als Kommunikationsroutine nach dem Standard ISO 15118 realisiert sein.

Für die Kommunikation der Funktionskomponenten der Versorgungsstation untereinander und/oder mit Dritten, beispielsweise einem Steuergerät des angeschlossenen elektrischen Betriebsmittels, kann eine Verschlüsselung und/oder Signatur vorgesehen sein. Hierdurch kann einer Manipulation wirksam entgegengewirkt werden.

Zusätzlich kann vorgesehen sein, dass das Steckelement unzugänglich im Inneren des Stationsgehäuses angeordnet ist, solange der Versorgungsstation keine gültige Nutzer- und/oder Kundenkennung übermittelt wurde. Das unzugängliche Anordnen des Steckelements in Inneren des Stationsgehäuses beugt insofern einer Manipulation vor. Insbesondere kann das Steckelement zu diesem Zweck hinter einer Klappe angeordnet sein. Die Klappe kann beispielsweise bedarfsgerecht von dem Steuercontroller verriegelt beziehungsweise entriegelt und/oder betätigt werden.

Nach einer Weiterbildung der Erfindung können der Messcontroller und der Steuercontroller gemeinsam durch einen Modulcontroller gebildet sein. Der Modulcontroller kann die Aufgaben beziehungsweise Funktionen des Messcontrollers und des Steuercontrollers übernehmen und eine gemeinsame Kommunikationsschnittstelle zum rückwirkungsfreien Senden und/oder Empfangen von Daten aufweisen.

Dem Messcontroller, dem Steuercontroller und/oder dem Modulcontroller kann ein Speicher zum Ablegen von Messwerten und/oder aus den Messwerten abgeleiteten beziehungsweise den Messwerten zugeordneten Daten zugeordnet sein. Beispielsweise können mit den Messwerten Datums- und Uhrzeitangaben sowie eine Dauer für den jeweiligen Versorgungsvorgang gespeichert werden. Zudem können an dem Zähler Bedienelemente vorgesehen sein zum Abfragen von den im Speicher abgelegten Messwerten beziehungsweise Daten. Die Messwerte des geeichten Zählers können beispielsweise von dem Messcontroller an ein mit diesem zusammenwirkendes Display übertragen und dort zur Anzeige gebracht werden. Angezeigt werden können neben den momentanen Messwerten insbesondere die in den Speicher abgelegten Messwerte beziehungsweise Daten.

Zur Lösung der Aufgabe weist die Erfindung die Merkmale des Patentanspruchs 16 auf. Demzufolge sieht ein Installationsverfahren für eine Versorgungsstation die folgenden Schritte vor:
- ein Versorgungspunktmodul umfassend mechanische Kontaktmittel zum elektrischen Kontaktieren des Versorgungspunktmoduls, ein Steckelement, einen geeichten Zähler und einen von dem Zähler zu dem Steckelement geführten Versorgungsmodulleiter wird werksseitig vormontiert zur Verfügung gestellt,
- das werksseitig vormontierte Versorgungspunktmodul wird in Bezug auf seine Messgenauigkeit überprüft, indem die mechanischen Kontaktmittel des Versorgungspunktmoduls elektrisch kontaktiert werden und an dem Steckelement ein Versorgungsstrom bereitgestellt wird und ein von der Messeinrichtung des Versorgungspunktmoduls ermittelter Modulmesswert mit einem Kontrollmesswert verglichen wird, der im Rahmen einer eichrechtsrelevanten Kontrollmessung mithilfe von Kontrollmessmitteln an dem Steckelement des Versorgungspunktmoduls bestimmt wird,
- wenn eine Abweichung zwischen dem Modulmesswert und dem Kontrollmesswert eine maximal zulässige Toleranzgrenze nicht überschreitet, wird das Versorgungspunktmodul für die Endmontage in der Versorgungsstation freigegeben,
- das geprüfte und freigegebene Versorgungspunktmodul wird werksseitig oder im Feld in eine Versorgungsstation eingebaut, wobei die mechanische Kontaktmittel des Versorgungspunktmoduls mit einer Versorgungspunktanschlussleitung der Versorgungsstation elektrisch verbunden werden und wobei das Versorgungspunktmodul in dem Stationsgehäuse montiert eine Kommunikationsschnittstelle des Versorgungspunktmoduls in Betrieb genommen wird.

Der besondere Vorteil der Erfindung besteht darin, dass die eichrechtsrelevante Kontrollmessung und die Überprüfung der Messgenauigkeit des geeichten Zählers werksseitig an dem Versorgungspunktmodul durchgeführt werden kann. Eine vorherige Integration des Versorgungspunktmoduls in der Versorgungsstation ist nicht erforderlich. Insbesondere ist eine Kontrollmessung am Installationsort der Versorgungsstation bei der Verwendung des erfindungsgemäßen Versorgungspunktmoduls entbehrlich. Der Installationsprozess beziehungsweise der Austausch des Versorgungspunktmoduls vereinfachen sich hierdurch signifikant.

Zusätzlich vereinfacht sich durch die Verwendung des erfindungsgemäßen Versorgungspunktmoduls die Wartung beziehungsweise Reparatur einer bereits installierten Versorgungsstation. Sofern Wartungs- beziehungsweise Reparaturarbeiten der Versorgungsstation das Versorgungspunktmodul nicht betreffen und beispielsweise an einem Manipulationsschutzgehäuse des Versorgungspunktmoduls vorgesehene Indikationsmittel nicht beschädigt werden, ist eine neue eichrechtsrelevante Kontrollmessung nach der Durchführung der Reparatur beziehungsweise Wartung nicht erforderlich. Darüber hinaus ist es möglich, bei einer Reparatur beziehungsweise Wartung, die das Versorgungspunktmodul betrifft, das in der Versorgungsstation verbaute Versorgungspunktmodul zu demontieren gegen ein werksseitig vorgefertigtes, alternatives Versorgungspunktmodul auszutauschen. Das alternative Versorgungspunktmodul ist insbesondere werksseitig kontrolliert. Es kann dann installiert werden, ohne dass nach der Installation die eichrechtsrelevante Kontrollmessung durchzuführen ist.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Erfindungsgemäß beschriebene Merkmale und Details der Versorgungsstation beziehungsweise des Versorgungspunktmoduls gelten selbstverständlich auch im Zusammenhang mit dem erfindungsgemäßen Installationsverfahren und umgekehrt. So kann auf die Offenbarung der einzelnen Erfindungsaspekte stets wechselseitig Bezug genommen werden. Die Zeichnungen dienen lediglich beispielhaft der Klarstellung der Erfindung. Sie haben keinen einschränkenden Charakter.

Es zeigen:
- Fig. 1: ein Blockschaltbild eines erfindungsgemäßen Versorgungspunktmoduls einer Versorgungsstation,
- Fig. 2: eine Versorgungsstation mit zwei Versorgungspunktmodulen,
- Fig. 3: eine Prinzipdarstellung einer ersten Ausführungsform eines Versorgungspunktmoduls und
- Fig. 4: eine Prinzipdarstellung einer zweiten Ausführungsform eines Versorgungspunktmoduls.

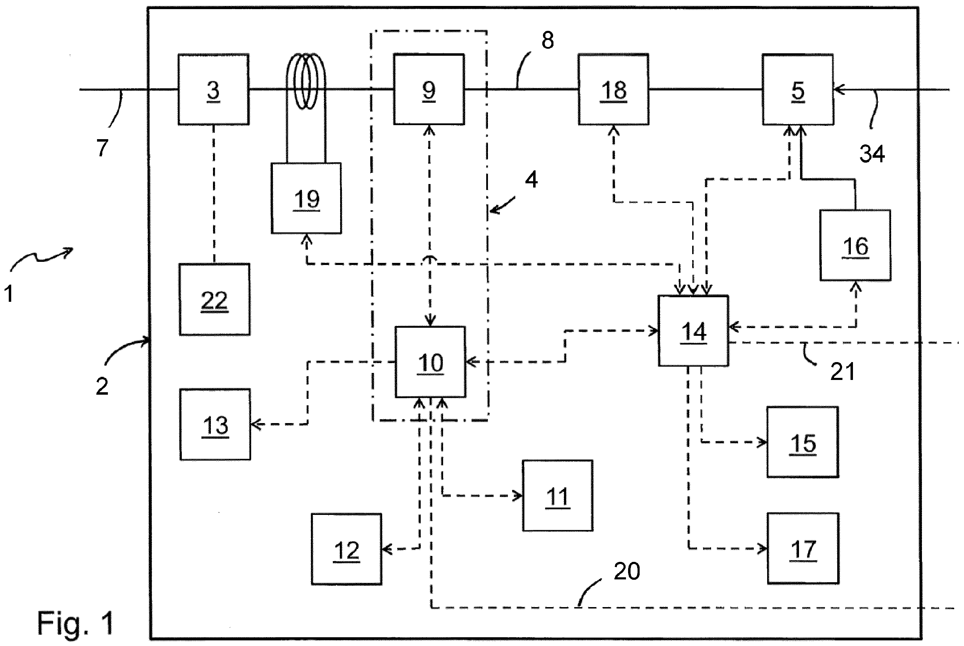

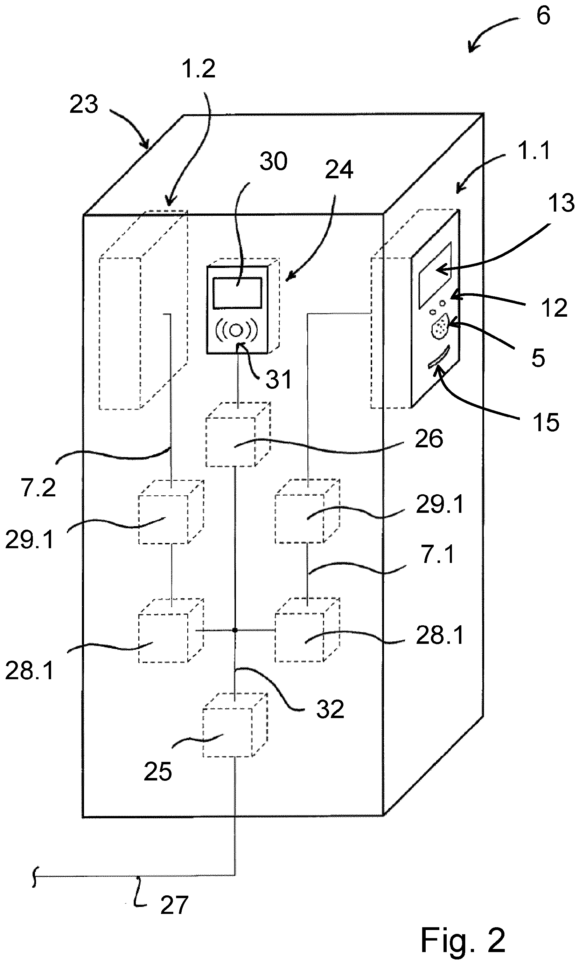

Ein Versorgungspunktmodul 1 nach Fig. 1 umfasst ein Manipulationsschutzgehäuse 2 sowie eine von dem Manipulationsschutzgehäuse 2 jedenfalls teilweise umfasste Anschlusseinheit 3, einen Zähler 4 und ein Steckelement 5. An äußere Kontakte des Steckelements 5 ist - in Fig. 1 symbolisch dargestellt - ein externes Anschlusskabel 34 mit einem nicht einzeln gezeigten Gegensteckelement angeschlossen. Das Versorgungspunktmodul 1 ist Teil einer Versorgungsstation 6. Die Versorgungsstation 6 mit ihren weiteren Funktionskomponenten ist in Fig. 2 dargestellt. Sie wird später im Detail beschrieben. Über das Anschlusskabel 34 ist die Versorgungsstation beispielsweise mit einem Fahrzeug verbunden.

Die Anschlusseinheit 3 des Versorgungspunktmoduls 1 weist nicht dargestellte mechanische Kontaktmittel auf. Über die mechanischen Kontaktmittel wird eine Versorgungspunktanschlussleitung 7 der Versorgungsstation 6 elektrisch leitend mit einem Versorgungsmodulleiter 8 des Versorgungspunktmoduls 1 verbunden. Der Versorgungsmodulleiter 8 ist von der Anschlusseinheit 3 zu einer Messeinrichtung 9 des Zählers 4 und weiter zu dem Steckelement 5 geführt. Dort ist der Versorgungsmodulleiter 8 mit inneren Kontakten des Steckelements 5 verbunden. Die dem Anschluss des Versorgungsmodulleiter 8 dienenden inneren Kontakte des Steckelements sind elektrisch leitend mit den äußeren Kontakt des Steckelements 5 verbunden.

Der Zähler 4 ist als ein geeichter Zähler 4 realisiert. Er sieht neben der Messeinrichtung 9 ein mit dem Messeinrichtung 9 zusammenwirkenden Messcontroller 10 vor. Der Messcontroller 10 ist insbesondere ausgebildet zur Entgegennahme und Verarbeitung von Messwerten, welche mittels der Messeinrichtung 9 bestimmt sind. Die Messeinrichtung 9 dient der Bestimmung eines elektrischen Betriebsparameters der Versorgungsstation 6. Insbesondere wird mittels der Messeinrichtung 9 eine über den Versorgungsmodulleiter 8 bereitgestellte elektrische Energie und/oder ein elektrischer Strom und/oder eine elektrische Spannung und/oder eine Frequenz bestimmt.

Der Messcontroller 10 wirkt im vorliegenden Ausführungsbeispiel mit einem Speicher 11 zusammen, der dazu dient, die Messwerte und/oder im Messcontroller aggregierten Werte zu speichern.

Ferner ist dem Messcontroller 10 ein Bedienelement 12 zugeordnet. Über das Bedienelement 12 kann ein Kunde mit der Messeinrichtung 9 in einer zuvor festgelegten Weise interagieren und insbesondere in dem Speicher 11 abgespeicherte Messwerte abfragen beziehungsweise aufrufen.

Zusätzlich ist ein Display 13 vorgesehen, welches mit dem Messcontroller 10 so zusammenwirkt, dass die aktuellen Messwerte beziehungsweise Zählerstände des Zählers 4 und die in dem Speicher 11 abgelegten Werte in dem Display 13 angezeigt werden können.

Das Versorgungspunktmodul 1 sieht ferner einen Steuercontroller 14 vor. Der Steuercontroller 14 wirkt zum einen mit einer Statussignalleuchte 15 zusammen, über die der Betriebszustand des Versorgungspunktmoduls 1 angezeigt werden kann. Zum anderen wird über den Steuercontroller 14 eine Verriegelung 16 betätigt, welche dem Steckelement 5 zugeordnet ist. Die Verriegelung 16 dient dazu, das in das Steckelement 5 eingesetzte Gegensteckelement in den Steckelement 5 festzulegen und gegen eine unbeabsichtigte beziehungsweise nicht autorisierte Entnahme zu sichern.

Von dem Steuercontroller 14 wird überdies eine dem Steckelement 5 zugeordnete Abdeckung 17 betätigt beziehungsweise verriegelt. Die Abdeckung 17 dient dazu, das Steckelement 5 in der Versorgungsstation 6 unzugänglich anzuordnen, wenn die Versorgungsstation 6 nicht verwendet wird und/oder kein autorisierter Zugriff auf die Versorgungsstation 6 stattfindet. In diesem Fall ist durch die Abdeckung 17 der Zugriff auf das Steckelement 5 gesperrt und einem Missbrauch ist ebenso vorgebeugt wie einem unbeabsichtigten Kontakt. Die Abdeckung 17 kann beispielsweise als aktorisch betätigbare Abdeckung 17 verschiebbar oder schwenkbar gestaltet sein. Beispielsweise kann die Abdeckung 17 manuell betätigt werden. Der Steuercontroller 14 kann dann vorgesehen sein zur Verriegelung beziehungsweise Freigabe der Abdeckung 17.

Dem Versorgungsmodulleiter 8 ist ein Schaltmittel 18 zugeordnet. Das Schaltmittel 18, das beispielsweise als ein Schütz ausgebildet ist, ist in dem Versorgungsmodulleiter 8 zwischen der Messeinrichtung 9 und dem Steckelement 5 vorgesehen. Der Steuercontroller 14 interagiert mit dem Schaltmittel 18. Insbesondere wird durch ein entsprechendes, von dem Steuercontroller 14 bereitgestelltes Betätigungssignal bedarfsgerecht eine elektrisch leitende Verbindung zwischen der Anschlusseinheit 3 und dem Steckelement 5 hergestellt beziehungsweise getrennt.

Mit dem Mikrocontroller 14 wirkt überdies ein Sensor 19 zusammen, welcher in einer Wirkverbindung mit dem Versorgungsmodulleiter 8 steht und einer Detektion von Fehlerströmen dient. Sofern mittels des Sensors 19 ein Fehlerstrom detektiert wird, kann der Ladevorgang vom Steuercontroller 14 unterbrochen werden.

Der Steuercontroller 14 steht überdies in einer Wirkverbindung mit dem Messcontroller 10. Beispielsweise können Messwerte des Zählers 4 an den Steuercontroller 14 übertragen und dort - etwa zu Abrechnungszwecken - einem speziellen Nutzerbeziehungsweise Kundenkonto zugewiesen werden.

Der Steuercontroller 14 verfügt im vorliegenden Ausführungsbeispiel der Erfindung ebenso wie der Messcontroller 10 über eine Kommunikationsschnittstelle 20, 21. Die Kommunikationsschnittstellen 20, 21 des Steuercontrollers 14 und des Messcontrollers 10 sind vorliegend rückwirkungsfrei ausgebildet. Sie erlauben bedarfsgerecht das Senden und/oder Empfangen von Daten. Die Kommunikationsschnittstellen 20, 21 können leitungsgebunden oder kabellos ausgebildet werden. Beispielsweise können optische Schnittstellen oder Funkschnittstellen realisiert werden.

Das Versorgungspunktmodul 1 umfasst funktional alle Komponenten, welche notwendig und erforderlich sind, um Verbrauchsdaten zu dem Ladevorgang zu ermitteln und zu speichern, die dem Kunden später in Rechnung gestellt werden.

Alle elektrischen beziehungsweise elektronischen Funktionskomponenten des Versorgungspunktmoduls 1 werden von einem AC/DC-Wandler 22 des Versorgungspunktmoduls 1 mit elektrischer Energie versorgt. Der Übersichtlichkeit halber sind von dem AC/DC-Wandler 22 zu den Funktionskomponenten geführte Versorgungsleitungen in Fig. 1 nicht einzeln dargestellt.

Das Versorgungspunktmodul 1 ist manipulationsgeschützt ausgebildet. Insofern sind an dem bevorzugten mehrteiligen Manipulationsschutzgehäuse 2 Indikationsmittel vorgesehen. Die Indikationsmittel verbinden beziehungsweise kennzeichnen die Gehäusekomponenten des Manipulationsschutzgehäuses 2 in der Art, dass ein Öffnen des Manipulationsschutzgehäuses 2 zu einer Schädigung des Indikationsmittels führt. Ein manipulativer Zugriff auf das Versorgungspunktmodul 1 kann insofern durch das beschädigte Indikationsmittel nachgewiesen beziehungsweise kenntlich gemacht werden. Die Indikationsmittel können beispielsweise für einen Kunden beziehungsweise Nutzer der Versorgungsstation von außen sichtbar vorgesehen werden. An einem Stationsgehäuse 23 der Versorgungsstation 6 können beispielsweise Sichtfenster vorgesehen werden, durch die der Kunde von außen die an dem Manipulationsschutzgehäuse 2 vorgesehenen Indikationsmittel in Augenschein nehmen kann.

Beispielsweise durch das Manipulationsschutzgehäuse 2 ist sichergestellt, dass der Versorgungsmodulleiter 8 jedenfalls abschnittweise zwischen der Messeinrichtung 9 und dem Steckelement 5 mechanisch unzugänglich und/oder gekapselt ausgebildet ist. Überdies sind mechanische Kontakte der Messeinrichtung 9, Kontakte des Schaltmittels 18 und die inneren Kontakte des Steckelements 5 mechanisch unzugänglich und/oder gekapselt angeordnet. Beispielsweise sind sie durch Indikationsmittel, insbesondere selbstklebende Siegel oder Prüfplaketten umhüllt oder überdeckt, so dass eine Kontaktierung der Kontakte nicht möglich ist beziehungsweise eine Manipulation erkennbar wird. Hierdurch ist gewährleistet, dass eine Energiemenge, welche dem Kunden auf Basis eines von Zähler 4 ermittelten Messwertes in Rechnung gestellt wird, tatsächlich über das Steckelement 5 bereitgestellt wird. Ein insbesondere in manipulativer Absicht durchgeführter Zwischenabgriff beispielsweise an mechanischen Kontaktmitteln des Schaltmittels 18 ist zuverlässig verhindert.

Fig. 2 zeigt die Versorgungsstation 6 mit dem Stationsgehäuse 23. Als Teil der Versorgungsstation 6 sind zwei Versorgungspunktmodule 1.1, 1.2 vorgesehen. Ferner sieht die Versorgungsstation 6 ein zentrales Steuermodul 24, ein Anschlussmodul 25 und ein dem zentralen Steuermodul 24 zugeordnetes Netzteil 26 vor.

Über das Anschlussmodul 25 ist die Versorgungsstation 6 an eine Zuleitung 27 eines externen, insbesondere öffentlichen Versorgungsnetzes angeschlossen. Von dem Anschlussmodul 25 ist je eine Versorgungspunktanschlussleitung 7.1., 7.2 zum Versorgungspunktmodul 1.1, 1.2 geführt. Den Versorgungspunktanschlussleitungen 7.1., 7.2 sind überdies je eine Leitungssicherung 28.1, 28.2 und ein Fehlerstrom-Schutzschalter 29.1, 29.2 zugeordnet. Zudem sind das zentrale Steuermodul 24 und das Netzteil 26 über eine Steuermodulversorgungsleistung 32 an das Anschlussmodul 25 angeschlossen.

Das zentrale Steuermodul 24 sieht ein Display 30 vor. Überdies sieht es eine Empfangseinheit 31 vor mittels der Empfangseinheit 31 kann insbesondere die Nutzer- und/oder Kundenkennung eingelesen werden.

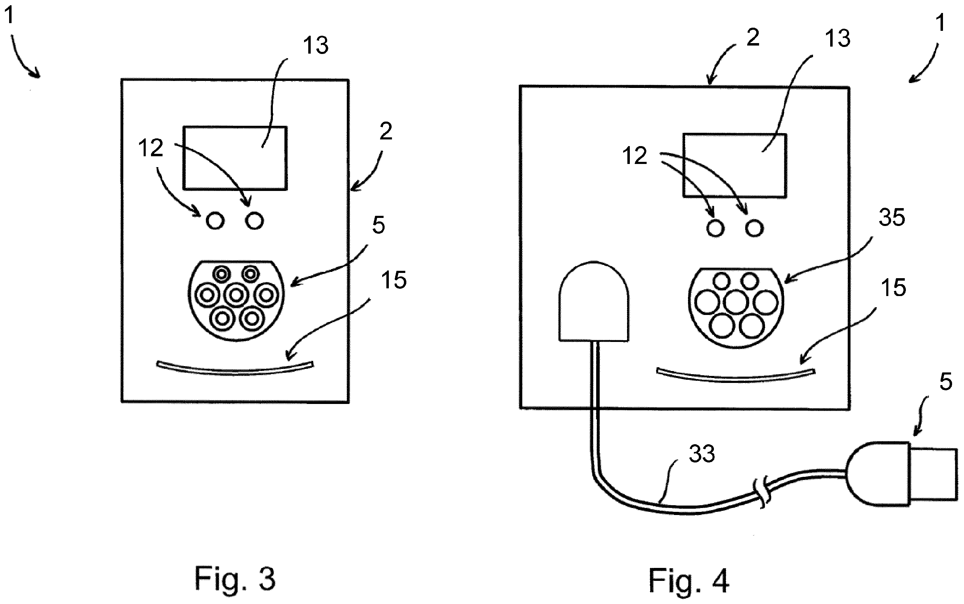

Zwei alternative Ausführungsformen des Versorgungspunktmoduls 1 sind in den Fig. 3 und 4 dargestellt.

Fig. 3 zeigt eine erste Ausführungsform, bei dem zwei Bedienelemente 12 des Versorgungspunktmoduls 1 unterhalb des Displays 13 angeordnet sind. Ferner umfasst das erste Versorgungspunktmodul 1 das Steckelement 5 und die Statussignalleuchte 15.

Das zweite Versorgungspunktmodul 1 nach Fig. 4 ist insbesondere in Bezug auf das Steckelement 5 modifiziert ausgebildet. Das Steckelement 5 ist über ein angeschlagenes Anschlusskabel 33 mit dem Versorgungspunktmodul 1 verbunden. Zwischen den Bedienelementen 12 und der Statussignalleuchte 15 ist ein elektrisch nicht kontaktierter Adapter 35 vorgesehen, indem das an dem Anschlusskabel 33 angeschlagene Steckelement 5 bei nicht Verwendung desselben eingesetzt werden kann.

Bei der erfindungsgemäßen Versorgungsstation 6 kann es sich um eine AC- oder eine DC-Versorgungsstation handeln. Ebenso kann das Versorgungspunktmodul als Versorgungspunktmodul in AC- beziehungsweise DC-Versorgungsstationen Verwendung finden.

Gleiche Bauteile und Bauteilfunktionen sind durch gleiche Bezugszeichen gekennzeichnet.

## Patentansprüche

1. Versorgungsstation (6) insbesondere zur Bereitstellung von elektrischer Energie für nicht-stationäre elektrische Betriebsmittel, umfassend ein Stationsgehäuse (23), welches die folgenden Funktionskomponenten der Versorgungsstation (6) jedenfalls abschnittsweise umgreift:
- ein zentrales Steuermodul (24), welches ausgebildet ist zur Verarbeitung einer Nutzer- und/oder Kundenkennung und/oder zur Koordination eines Ladevorgangs,
- ein Versorgungspunktmodul (1, 1.1, 1.2) mit einem Steckelement (5), welches innere und äußere elektrisch leitende Kontakte vorsieht, wobei die inneren Kontakte elektrisch leitend mit den äußeren Kontakten verbunden sind, wobei die inneren Kontakte mit einem Versorgungsmodulleiter (8) verbunden sind und wobei die äußeren Kontakte mittelbar oder unmittelbar mit dem nicht-stationären elektrischen Betriebsmittel verbindbar ist,
- eine zu dem Versorgungspunktmodul (1, 1.1, 1.2) geführte Versorgungspunktanschlussleitung (7, 7.1, 7.2),
wobei das Versorgungspunktmodul (1, 1.1, 1.2) als ein eigenständiges, werksseitig vormontiertes Submodul der Versorgungsstation (6) das Steckelement (5), mechanische Kontaktmittel zum elektrischen Kontaktieren des Versorgungspunktmoduls (1, 1.1, 1.2) und einen Zähler (4) mit einer Messeinrichtung (9) und einem Messcontroller (10) umfasst, wobei die Versorgungspunktanschlussleitung (7, 7.1, 7.2) über die mechanischen Kontaktmittel mit der Versorgungsmodulleitung (8) verbunden ist, wobei der Versorgungsmodulleiter (8) die Messeinrichtung (9) des Zählers (4) mit dem Steckelement (5) verbindet, wobei der Messcontroller (10) ausgebildet ist zur Verarbeitung von Messwerten, welche mittels der Messeinrichtung (9) bestimmt sind, und wobei das Versorgungspunktmodul (1, 1.1, 1.2) als ein manipulationsgeschütztes Versorgungspunktmodul (1., 1.1, 1.2) ausgebildet ist derart, dass eine Kommunikationsschnittstelle des Versorgungspunktmoduls (1, 1.1, 1.2) rückwirkungsfrei ausgebildet ist.

2. Versorgungsstation (6) nach Anspruch 1, **dadurch gekennzeichnet, dass** das Versorgungspunktmodul (1, 1.1, 1.2) als ein manipulationsgeschütztes Versorgungspunktmodul (1, 1.1, 1.2) ausgebildet ist derart, dass der Versorgungsmodulleiter (8) wenigstens abschnittweise und jedenfalls von der Messeinrichtung (9) zu dem Steckelement (5) und/oder mechanische Kontakte der Messeinrichtung (9) und die inneren Kontakte des Steckelements (5) mechanisch unzugänglich und/oder gekapselt angeordnet sind.

3. Versorgungsstation (6) nach Anspruch 1 oder 2, **dadurch gekennzeichnet, dass** das Versorgungspunktmodul (1, 1.1, 1.2) ein mehrteiliges Manipulationsschutzgehäuse (2) vorsieht und dass jedenfalls einzelne und bevorzugt alle Gehäusekomponenten des Manipulationsschutzgehäuses (2) durch Indikationsmittel derart gekennzeichnet und/oder verbunden sind, dass ein Öffnen des Manipulationsschutzgehäuses (2) zu einer Beschädigung der Indikationsmittel führt, und/oder dass das Manipulationsschutzgehäuse (2) von dem Stationsgehäuse (23) umgriffen ist, wobei an dem Stationsgehäuse (23) und/oder an dem Manipulationsgehäuse (2) eine Ausnehmung vorgesehen ist, über die das Steckelement (5) des Versorgungspunktmoduls (1, 1.1, 1.2) von außen zugänglich und/oder nach außen geführt ist.

4. Versorgungsstation (6) nach einem der Ansprüche 1 bis 3, **dadurch gekennzeichnet, dass** eine Empfangseinheit (31) zum Empfangen der Nutzer- und/oder Kundenkennung vorgesehen ist, wobei die Empfangseinheit (31) als eine weitere Funktionskomponente des Versorgungspunktmoduls (1, 1.1, 1.2) oder als außerhalb des Versorgungspunktmoduls (1, 1.1, 1.2) vorgesehen ist und dabei bevorzugt einen Teil des zentralen Steuermoduls (24) bildet, und/oder dass der Versorgungspunktanschlussleitung (7, 7.1, 7.2) eine Leitungssicherung (28.1, 28.2) und/oder ein Fehlerstrom-Schutzschalter (29.1, 29.2) zugeordnet sind.

5. Versorgungsstation (6) nach einem der Ansprüche 1 bis 4, **dadurch gekennzeichnet, dass** das Versorgungspunktmodul (1, 1.1, 1.2) eine die mechanischen Kontaktmittel bereitstellende Anschlusseinheit (3) vorsieht, wobei der Versorgungsmodulleiter (8) die Anschlusseinheit (3) mit der Messeinrichtung (9) verbindet, und/oder dass in dem Stationsgehäuse (23) getrennt von dem Versorgungspunktmodul (1, 1.1, 1.2) ein Anschlussmodul (25) vorgesehen ist, wobei das Anschlussmodul (25) mechanische Kontakte vorsieht zum elektrisch leitenden Kontaktieren einer Zuleitung (27) mit der Versorgungspunktanschlussleitung (7, 7.1, 7.2).

6. Versorgungsstation (6) nach einem der Ansprüche 1 bis 5, **dadurch gekennzeichnet, dass** wenigstens zwei Versorgungspunktmodule (1, 1.1, 1.2) mit jeweils einem Steckelement (5), mit jeweils eigenen mechanischen Kontaktmitteln, mit jeweils einer Messeinrichtung (9) und mit jeweils einem Messcontroller (10) vorgesehen sind und/oder dass das Anschlussmodul (25) als ein gemeinsames Anschlussmodul (25) der Versorgungspunktmodule (1, 1.1, 1.2) ausgebildet ist derart, dass von dem gemeinsamen Anschlussmodul (25) zu den mechanischen Kontaktmitteln eines jeden Versorgungspunktmoduls (1, 1.1, 1.2) jeweils eine Versorgungspunktanschlussleitung (7, 7.1, 7.2) geführt ist.

7. Versorgungsstation (6) nach Anspruch 6 **dadurch gekennzeichnet, dass** für jedes der wenigstens zwei Versorgungspunktmodule (1, 1.1, 1.2) eine separate Zuleitung (27) zu dem Stationsgehäuse (23) geführt ist

8. Versorgungspunktmodul (1, 1.1, 1.2), insbesondere für eine Versorgungsstation (6) nach einem der Ansprüche 1 bis 7, umfassend
- ein Steckelement (5), welches innere und äußere Kontakte vorsieht, wobei die inneren Kontakte elektrisch leitend mit den äußeren Kontakten verbunden sind, wobei die inneren Kontakte mit einem Versorgungsmodulleiter (8) verbunden sind und wobei die äußeren Kontakte mittelbar oder unmittelbar mit einem nicht-stationären elektrischen Betriebsmittel verbindbar ist,
- mechanische Kontaktmittel, welche ausgebildet sind zum Anschluss einer Versorgungspunktanschlussleitung (7, 7.1, 7.2),
- den Versorgungsmodulleiter (8), welcher elektrisch leitend mit den mechanischen Kontaktmitteln und mit den inneren Kontakten des Steckelements (5) verbunden ist,
- eine dem Versorgungsmodulleiter (8) zugeordnete Messeinrichtung (9) zum Messen eines elektrischen Betriebsparameters und insbesondere einer über den Versorgungsmodulleiter (8) bereitgestellten elektrischen Energie und/oder einer elektrischen Leistung und/oder eines elektrischen Stroms und/oder einer elektrischen Spannung und/oder einer Frequenz,
- einen mit der Messeinrichtung (9) zusammenwirkenden Messcontroller (10) mit einer Recheneinheit zum Verarbeiten von Messwerten der Messeinrichtung (9),
wobei der Versorgungsmodulleiter (8) wenigstens abschnittweise und jedenfalls von der Messeinrichtung (9) bis zu den inneren Kontakten des Steckelements (5) und/oder mechanische Kontakte der Messeinrichtung (9) und/oder die inneren Kontakte des Steckelements (5) mechanisch unzugänglich und/oder gekapselt angeordnet sind und/oder wobei wenigstens eine Kommunikationsschnittstelle (20, 21) vorgesehen ist und wobei die wenigstens eine Kommunikationsschnittstelle (20, 21) des Versorgungspunktmodul (1, 1.1, 1.2) rückwirkungsfrei ausgebildet ist.

9. Versorgungspunktmodul (1, 1.1, 1.2) nach Anspruch 8, **dadurch gekennzeichnet, dass** der Messcontroller (9) eine Kommunikationsschnittstelle (20) vorsieht, welche ausgebildet ist zum Senden und/oder rückwirkungsfreien Empfangen von Daten, und/oder dass dem Versorgungsmodulleiter (8) ein Schaltmittel (18) zugeordnet ist zum Herstellen und/oder Trennen einer elektrisch leitenden Verbindung zwischen dem Steckelement (5) und den mechanischen Kontaktmitteln, wobei das Schaltmittel (18) in dem Versorgungsmodulleiter (8) bevorzugt zwischen der Messeinrichtung (9) und dem Steckelement (5) angeordnet ist.

10. Versorgungspunktmodul (1, 1.1, 1.2) nach einem der Ansprüche 8 oder 9, **dadurch gekennzeichnet, dass** ein das Steckelement (5) und den Versorgungsmodulleiter (8) und die Messeinrichtung (9) und den Messcontroller (10) und optional das Schaltmittel (18) jedenfalls abschnittsweise umgreifendes Manipulationsschutzgehäuse (2) vorgesehen ist, wobei das Manipulationsschutzgehäuse (2) mehrteilig ausgebildet ist, wobei wenigstens einige und bevorzugt alle Gehäusekomponenten des Manipulationsschutzgehäuses (2) durch wenigstens ein Indikationsmittel derart gekennzeichnet und/oder miteinander verbunden sind, dass ein Öffnen des Manipulationsschutzgehäuses (2) zu einer Beschädigung des Indikationsmittels führt.

11. Versorgungspunktmodul (1, 1.1, 1.2) nach einem der Ansprüche 8 bis 10, **dadurch gekennzeichnet, dass** jedenfalls einzelnen mechanischen Kontakten der Messeinrichtung (9) und/oder Kontakten des Schaltmittels (18) und den inneren Kontakten des Steckelements (5) Indikationsmittel zugeordnet sind derart, dass eine elektrisch leitenden Kontaktierung der durch die Indikationsmittel geschützten mechanischen Kontakte der Messeinrichtung (9) und/oder Kontakte des Schaltmittels (18) und inneren Kontakte des Steckelements (5) zu einer Schädigung der Indikationsmittel führt.

12. Versorgungspunktmodul (1, 1.1, 1.2) nach einem der Ansprüche 8 bis 11, **dadurch gekennzeichnet, dass** die mechanischen Kontaktmittel des Versorgungspunktmoduls (1, 1.1, 1.2) an der Messeinrichtung (9) vorgesehen sind, und/oder dass das Versorgungspunktmodul (1, 1.1, 1.2) eine die mechanischen Kontaktmittel bereitstellende Anschlusseinheit (3) vorsieht und dass der Versorgungsmodulleiter (8) die Anschlusseinheit (3) mit der Messeinrichtung (9) verbindet.

13. Versorgungspunktmodul (1, 1.1, 1.2) nach einem der Ansprüche 8 bis 12, **dadurch gekennzeichnet, dass** dem Zähler (4) ein Speicher (11) zum Ablegen der Messwerte und/oder Daten und/oder ein Bedienelement (12) zum Abfragen und/oder Anzeigen der in dem Speicher (11) abgelegten Messwerten und/oder Daten zugeordnet ist und/oder dass die Messeinrichtung (9) und der Messcontroller (10) Teil eines geeichten Zählers (4) sind und/oder dass ein mit dem Messcontroller (10) zusammenwirkendes Display (13) vorgesehen ist zur Anzeige von aktuellen Messwerten des geeichten Zählers (4) und/oder der in dem Speicher (11) abgelegten Messwerte und/oder Daten.

14. Versorgungspunktmodul (1, 1.1, 1.2) nach einem der Ansprüche 8 bis 13, **dadurch gekennzeichnet, dass** ein mit dem Messcontroller (10) zusammenwirkender Steuercontroller (14) vorgesehen ist mit einer Kommunikationsschnittstelle (21) zum Senden und/oder rückwirkungsfreien Empfangen von Daten, wobei der Steuercontroller (14) ausgebildet ist zum Betätigen des Schaltmittels (18) und/oder zum Betätigen einer dem Steckelement (5) zugeordneten Verriegelung (16) und/oder einer Statussignalleuchte (15) und/oder zum Kommunizieren mit dem elektrischen Betriebsmittel und/oder zur Detektion eines in das Steckelement (5) eingesetzten Gegensteckelements.

15. Versorgungspunktmodul (1, 1.1, 1.2) nach Anspruch 14, **dadurch gekennzeichnet, dass** der Messcontroller (10) und der Steuercontroller (14) durch einen gemeinsamen Modulcontroller gebildet sind und/oder dass der Modulcontroller über eine gemeinsame Kommunikationsschnittstelle zum Senden und/oder rückwirkungsfreien Empfangen von Daten verfügt.

16. Installationsverfahren für eine Versorgungsstation (6), insbesondere für eine Versorgungsstation (6) nach einem der Ansprüche 1 bis 7 mit einem Versorgungspunktmodul (1, 1.1, 1.2) nach einem der Ansprüche 8 bis 15, umfassend die folgenden Verfahrensschritte:
- ein Versorgungspunktmodul (1, 1.1, 1.2) umfassend mechanische Kontaktmittel zum elektrischen Kontaktieren des Versorgungspunktmoduls (1, 1.1, 1.2), ein Steckelement (5), einen Zähler (4) und einen von dem Zähler (4) zu dem Steckelement (5) geführten Versorgungsmodulleiter (8) wird werksseitig vormontiert zur Verfügung gestellt,
- das werksseitig vormontierte Versorgungspunktmodul (1, 1.1, 1.2) wird in Bezug auf seine Messgenauigkeit überprüft, indem die mechanischen Kontakte des Versorgungspunktmoduls (1, 1.1, 1.2) elektrisch kontaktiert werden und an dem Steckelement (5) ein Versorgungsstrom bereitgestellt wird und ein von der Messeinrichtung (9) des Versorgungspunktmoduls (1, 1.1, 1.2) ermittelter Modulmesswert mit einem Kontrollmesswert verglichen wird, der im Rahmen einer eichrechtlich relevanten Kontrollmessung mithilfe von Kontrollmessmitteln an dem Steckelement (5) des Versorgungspunktmoduls (1, 1.1, 1.2) bestimmt wird,
- wenn eine Abweichung zwischen dem Modulmesswert und dem Kontrollmesswert eine maximal zulässige Toleranzgrenze nicht überschreitet, wird das Versorgungspunktmodul (1, 1.1, 1.2) für die Endmontage in der Versorgungsstation (6) freigegeben,
- das geprüfte und freigegebene Versorgungspunktmodul (1, 1.1, 1.2) wird werksseitig oder am Installationsort in eine Versorgungsstation (6) eingebaut, wobei die mechanische Kontaktmittel mit einer Versorgungspunktanschlussleitung (7, 7.1, 7.2) der Versorgungsstation elektrisch verbunden werden und wobei das Versorgungspunktmodul (1, 1.1, 1.2) in und/oder an dem Stationsgehäuse (23) montiert und eine Kommunikationsschnittstelle (20, 21) des Versorgungspunktmoduls (1, 1.1, 1.2) in Betrieb genommen wird.

17. Installationsverfahren nach Anspruch 16, **dadurch gekennzeichnet, dass** an dem Versorgungspunktmodul (1, 1.1, 1.2) und bevorzugt an einem Manipulationsschutzgehäuse (2) des Versorgungspunktmoduls (1, 1.1, 1.2) eine Freigabekennzeichnung und/oder ein Indikationsmittel angebracht wird, sofern die Abweichung zwischen dem Modulmesswert und dem Kontrollmesswert die maximal zulässige Toleranzgrenze nicht überschreitet.
